# EUROPEAN PATENT APPLICATION

(11) **EP 4 841 284 A1**
(43) Date of publication of application: **18.11.2026**
(21) Application number: 26169753.6
(22) Date of filing: 31.03.2026
(51) Int. Cl.: G01R 31/392

(54) **BATTERY MANAGEMENT SYSTEM AND BATTERY MANAGEMENT METHOD**

(30) Priority: 13.05.2025 JP 2025080734
(71) Applicant: TOYOTA JIDOSHA KABUSHIKI KAISHA, Toyota-shi, Aichi-ken 471-8571 (JP)
(72) Inventor: YOKOYAMA, Daiki, Toyota-shi 471-8571 (JP); YOKOYAMA, Kouichi, Toyota-shi 471-8571 (JP)
(74) Representative: J A Kemp LLP

(57) **Abstract**

A battery management system (100) includes: a use information acquisition unit (501, 502) that acquires use information indicating a manner of use of a battery (61, 62); a model storage unit (505) that stores a plurality of trained models (525) each trained to estimate a battery parameter indicating a state of the battery, based on the use information; and a model selection unit (506) that selects one trained model from among the plurality of trained models (525). When the manner of use of the battery is changed during a period in which a first model among the plurality of trained models (525) is used, the model selection unit (506) changes the trained model so as to use a second model dependent on the changed manner of use, among the plurality of trained models (525).

## Description

### CROSS REFERENCE TO RELATED APPLICATIONS

This nonprovisional application is based on Japanese Patent Application No. 2025-080734 filed on May 13, 2025 with the Japan Patent Office, the entire contents of which are hereby incorporated by reference.

### BACKGROUND

### Field

The present disclosure relates to a battery management system and a battery management method.

### Description of the Background Art

In recent years, in order to reduce the environmental load, reuse of a battery mounted on a vehicle or the like has been required. Various techniques related to battery reuse have been proposed. Japanese Patent Laying-Open No. 2022-136662 discloses a learning method by machine learning for a state estimation model that estimates a state of charge and/or a degree of deterioration of an operating secondary battery to which a load or a charger is connected.

### SUMMARY

It has been proposed to use a trained model generated by machine learning, in order to estimate a battery parameter indicating a state of a battery (a parameter indicating a state of charge, a state of health, or the like). It is desirable to be able to estimate a battery parameter with high accuracy using a machine learning model.

The present disclosure is made to solve the above-described problem, and one of the objects of the present disclosure is to estimate a battery parameter with high accuracy using a machine learning model.

A battery management system according to a first aspect of the present disclosure includes: a use information acquisition unit that acquires use information indicating a manner of use of a battery; a model storage unit that stores a plurality of trained models each trained to estimate a battery parameter indicating a state of the battery, based on the use information; and a model selection unit that selects a trained model from among the plurality of trained models. When the manner of use of the battery is changed during a period in which a first model among the plurality of trained models is used, the model selection unit changes the trained model so as to use a second model dependent on the changed manner of use, among the plurality of trained models.

A battery management method according to a second aspect of the present disclosure includes: acquiring use information indicating a manner of use of a battery; selecting a trained model from among a plurality of trained models each trained to estimate a battery parameter indicating a state of the battery, based on the use information. The selecting includes changing, when the manner of use of the battery is changed during a period in which a first model among the plurality of trained models is used, the trained model so as to use a second model dependent on the changed manner of use, among the plurality of trained models.

In some cases, the manner of use of the battery may be changed during a period in which the trained model selected once is used. According to the above-described configuration and method, when the manner of use of the battery is changed during a period in which a first model among the plurality of trained models is used, the trained model is changed so as to use a second model dependent on the changed manner of use, among the plurality of trained models. Accordingly, a trained model conforming to or optimized for the changed manner of use is used, and therefore, the battery parameter can be estimated with high accuracy.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a block diagram illustrating an example of an overall configuration of a battery management system according to an embodiment of the present disclosure.
Fig. 2 is a block diagram illustrating an example of configurations of a battery management server and a second server.
Fig. 3 is a diagram for explaining an example of each of a plurality of trained models.
Fig. 4 is a conceptual diagram for explaining selection of a trained model according to the present embodiment.
Fig. 5 is a diagram for explaining an example of classification of use patterns.
Fig. 6 is a diagram illustrating a use pattern table.
Fig. 7 is a flowchart illustrating an example of a processing procedure relating to acquisition of battery information and generation of primary use information during primary use of a battery.
Fig. 8 is a flowchart illustrating an example of a processing procedure relating to transmission and reception of primary use information.
Fig. 9 is a flowchart illustrating an example of a processing procedure relating to the start of secondary use of a battery.
Fig. 10 is a flowchart illustrating an example of a processing procedure relating to selection of a trained model.
Fig. 11 is a flowchart illustrating an example of a processing procedure relating to inference using a trained model.

### DESCRIPTION OF THE PREFERRED EMBODIMENTS

Hereinafter, embodiments of the present disclosure will be described in detail with reference to the drawings. In the drawings, the same or corresponding parts are denoted by the same reference characters, and the description thereof will not be repeated.

### [Embodiments]

### <Overall System Configuration>

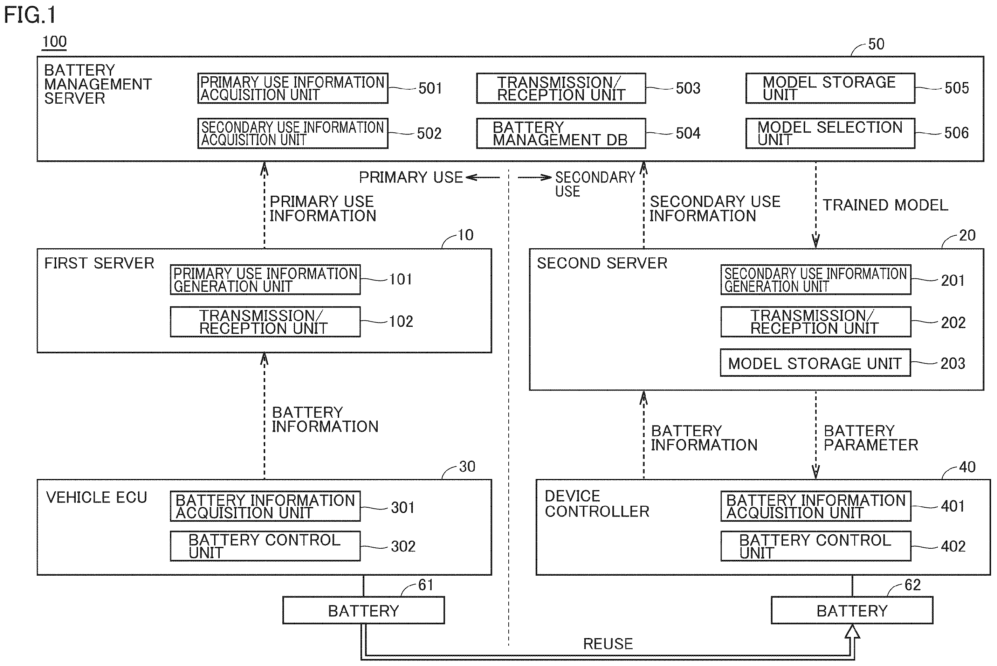

Fig. 1 is a block diagram illustrating an example of an overall configuration of a battery management system according to an embodiment of the present disclosure. The battery management system 100 includes a first server 10, a second server 20, a vehicle ECU (Electronic Control Unit) 30, a device controller 40, and a battery management server 50.

In the present embodiment, as one exemplary embodiment, it is assumed that a battery is used for a vehicle in primary use, while the battery is used for a stationary use in secondary use. That is, a battery 61 mounted on a vehicle is reused as a battery 62 of a stationary power supply system. However, the applications of the batteries 61 and 62 are not particularly limited. The applications may be opposite to those in this example. Alternatively, both primary use and secondary use applications may be those for the vehicle, or both primary use and secondary use applications may be those for the stationary use.

Each of the batteries 61 and 62 is a battery assembly including a plurality of secondary batteries. The types of the batteries 61 and 62 are not particularly limited. The batteries 61 and 62 may be, for example, lithium ion batteries, nickel-metal hydride batteries, or all-solid-state batteries. Each of the batteries 61 and 62 is assigned an identification number (hereinafter, it is referred to as "battery ID") unique to the battery.

The first server 10 is a server for managing primary use of the battery 61. The first server 10 is managed and operated by, for example, a manufacturer of the vehicle. The first server 10 includes a primary use information generation unit 101 and a transmission/reception unit 102.

The primary use information generation unit 101 generates primary use information indicating a manner of use of the battery 61 during primary use of the battery 61. The transmission/reception unit 102 is configured to transmit and receive information to and from external devices (such as the vehicle ECU 30 and the battery management server 50). The primary use information generation unit 101 acquires battery information (such as data measured by various sensors mounted on the vehicle) from the vehicle ECU 30, and generates primary use information based on the acquired battery information. The primary use information includes a use history of the battery 61 during primary use. The primary use information may include, for example, a temperature history (such as a temporal change or a frequency distribution of the temperature) of the battery 61 during primary use (both during charging and discharging and during a pause). The primary use information may include a charging and discharging history (such as a temporal change or a frequency distribution of a voltage and/or a current) of the battery 61 during primary use (during charging and discharging). The primary use information may include the number of times the battery 61 has been charged and discharged during primary use, and may include a start time and/or an end time of charging/discharging of the battery 61 during primary use. The primary use information may include an amount of change in shape (expansion amount or the like) of the battery 61. The primary use information generation unit 101 transmits the primary use information to the battery management server 50 via the transmission/reception unit 102.

The second server 20 is a server for managing secondary use of the battery 62. For example, the second server 20 may be managed and operated by a manufacturer of the vehicle or may be managed and operated by an administrator of the stationary power supply system. The second server 20 includes a secondary use information generation unit 201, a transmission/reception unit 202, and a model storage unit 203.

The secondary use information generation unit 201 generates secondary use information indicating a manner of use of the battery 62 during secondary use of the battery 62. The transmission/reception unit 202 is configured to transmit and receive information to and from external devices (such as the device controller 40 and the battery management server 50). The secondary use information generation unit 201 acquires battery information (data measured by various sensors arranged in the stationary power supply system) from the device controller 40, and generates secondary use information based on the acquired battery information. Similarly to the primary use information, the secondary use information may include a temperature history, a charging and discharging history, the number of times the battery 62 has been charged and discharged, a start time and/or an end time of charging/discharging, an amount of change in shape, and the like, of the battery 62 during secondary use. The secondary use information generation unit 201 transmits the secondary use information to the battery management server 50 via the transmission/reception unit 202. The model storage unit 203 stores the trained model provided from the battery management server 50.

The vehicle ECU 30 controls a vehicle (not shown) on which the battery 61 that is used in the primary use is mounted. The vehicle ECU 30 includes a battery information acquisition unit 301 and a battery control unit 302.

The battery information acquisition unit 301 acquires battery information regarding the battery 61 during primary use. As described above, the battery information includes data (such as temperature, voltage, and/or current changes over time) measured by various sensors mounted on the vehicle. The battery control unit 302 controls charging and discharging of the battery 61 according to the battery information. The vehicle ECU 30 transmits the battery information acquired from the vehicle to the first server 10 via a data communication module (DCM) (not shown).

The device controller 40 controls a stationary power supply system in which the secondary battery 62 for secondary use (reuse of the battery 61 for primary use) is disposed. The device controller 40 includes a battery information acquisition unit 401 and a battery control unit 402.

The battery information acquisition unit 401 acquires battery information regarding the battery 62 during secondary use. The battery information includes data (raw data indicating temporal changes in temperature, voltage, and/or current) measured by various sensors provided in the stationary power supply system. The battery control unit 402 controls charging and discharging of the battery 62 according to the battery information. The device controller 40 transmits the battery information acquired from the stationary power supply system to the second server 20.

The battery management server 50 manages batteries for both primary use and secondary use. The battery management server 50 includes a primary use information acquisition unit 501, a secondary use information acquisition unit 502, a transmission/reception unit 503, a battery management database 504, a model storage unit 505, and a model selection unit 506.

The primary use information acquisition unit 501 acquires primary use information from the first server 10. The secondary use information acquisition unit 502 acquires secondary use information from the second server 20. The transmission/reception unit 503 is configured to transmit and receive information (primary use information, secondary use information, and the like) to and from external devices (the first server 10, the second server 20, and the like). The battery management database 504 stores various pieces of information (such as a use pattern map described later) for managing the batteries 61 and 62 in association with the battery IDs.

The model storage unit 505 stores a plurality of trained models for estimating various battery parameters relating to the battery 61 during secondary use. The battery parameter is a parameter indicating a state of the battery 62, and typically includes a state of charge (SOC) of the battery 62. The battery parameters may include a state of health (SOH) (full charge capacity, capacity retention ratio, etc.) of the battery 62. However, the battery parameter is not limited thereto, and may include a self-discharge amount of the battery 62, and may include a value indicating an abnormality of the battery 62 (such as excessive expansion of the electrode assembly, short circuit in the electrode assembly, or leakage of an electrolyte solution).

The model selection unit 506 selects any trained model from among the plurality of trained models based on the primary use information and the secondary use information. The model selection unit 506 provides the selected trained model to the second server 20.

### <Configuration of Each Device>

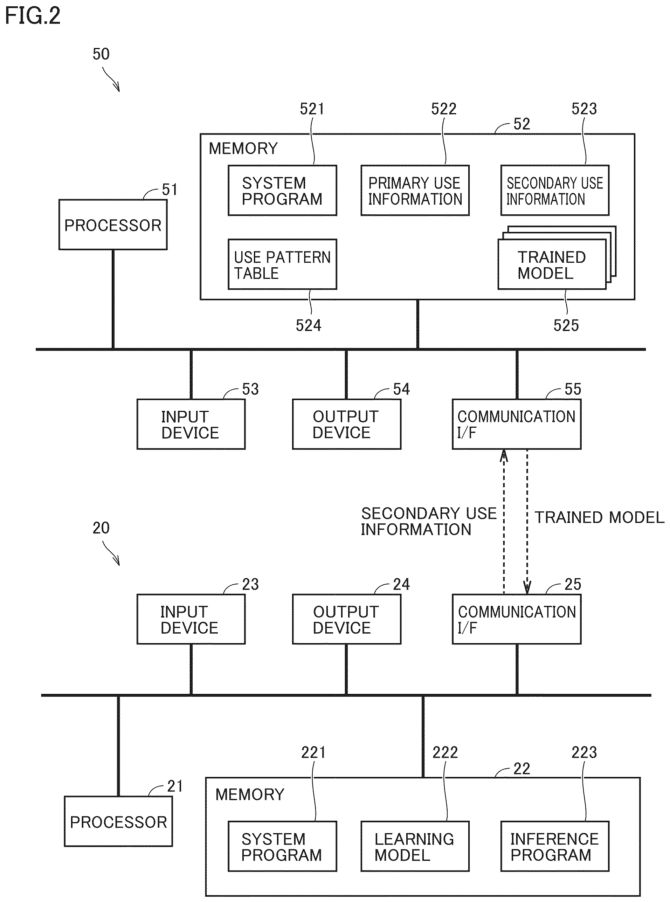

Fig. 2 is a block diagram showing an example of the configurations of the battery management server 50 and the second server 20. The battery management server 50 includes, for example, a processor 51, a memory 52, an input device 53, an output device 54, and a communication interface 55.

The processor 51 is an arithmetic processing device such as central processing unit (CPU) or micro processing unit (MPU). The processor 51 implements various arithmetic processing by reading a program, a parameter, a map, a learning model, and the like stored in the memory 52 and deploying them in the memory 52. Note that, in the present specification, the "processor" is not limited to a processor in a narrow sense that executes processing by a stored program method, and may include a hardwired circuit such as ASIC (Application Specific Integrated Circuit), FPGA (Field-Programmable Gate Array). As such, the term "processor" may also be read to refer to processing circuitry in which processing is predefined by computer readable code and/or hardwired circuitry.

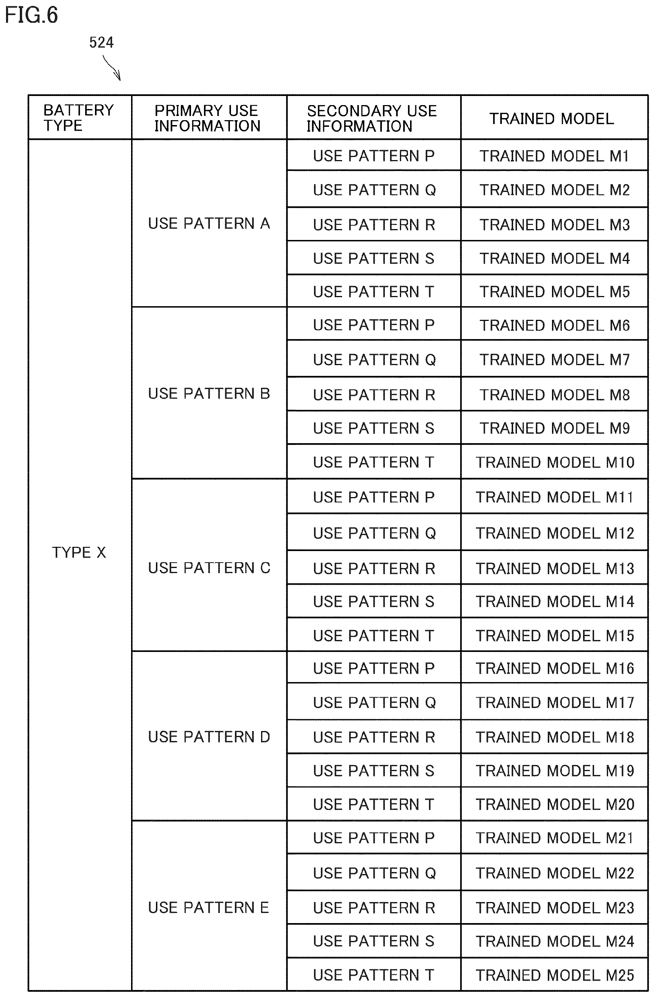

The memory 52 includes, for example, a volatile storage device such as DRAM (Dynamic Random Access Memory) or SRAM (Static Random Access Memory), and a nonvolatile storage device such as HDD (Hard Disk Drive), SSD (Solid State Drive), or flash memory. The memory 52 stores a system program 521 including an OS (Operating System), primary use information 522, secondary use information 523, a use pattern table 524 (see Fig. 6 to be described later) in which the manners of use of a battery are classified into patterns, and a plurality of trained models 525 each trained to estimate a battery parameter from a use history of the battery.

The input device 53 is a keyboard, a mouse, a touch panel, an operation button, or the like, and is configured to receive an operation by a user of the battery management server 50 (for example, a person in charge of a battery reuse provider). The output device 54 is a monitor, a printer, or the like, and is configured to output the progress and the result of the arithmetic processing by the processor 51. The communication interface 55 is configured to transmit and receive information to and from the outside via the transmission/reception unit 503 (see Fig. 1).

The second server 20 includes, for example, a processor 21, a memory 22, an input device 23, an output device 24, and a communication interface 25.

The processor 21 is an arithmetic processing device similar to the processor 51. Like the memory 52, the memory 22 includes a volatile storage device and a nonvolatile storage device. The processor 21 implements various arithmetic processing by reading a program or the like stored in the memory 22 and deploying the program or the like in the memory 22. The memory 22 stores a system program 221, a trained model 222 provided from the battery management server 50, and an inference program 223 for executing inference (estimation of battery parameters) using the trained model 222.

The input device 23, the output device 24, and the communication interface 25 are equivalent to the corresponding devices of the battery management server 50.

### <Machine Learning Model>

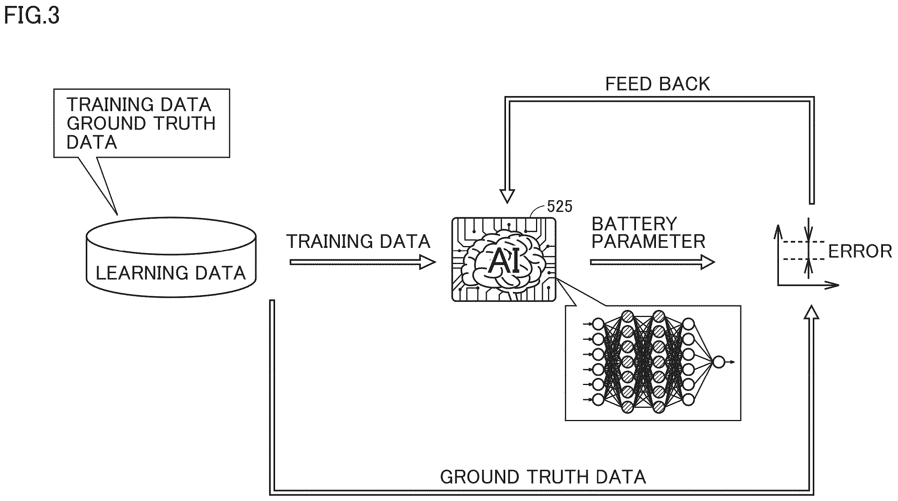

Fig. 3 is a diagram for explaining an example of each of the plurality of trained models 525 (that is, the trained model 222). Referring to Figs. 1 to 3, each of the plurality of trained models 525 is, for example, a neural network model. Techniques such as convolutional neural network (CNN), residual neural network (ResNet), generative adversarial network (GAN), stacked autoencoder, and transformer may be used to generate the trained model 525.

The battery management server 50 uses the learning data to train the learning model. More specifically, in this example, the learning data includes training data and ground truth data (ground truth label) (supervised machine learning). The battery management server 50 inputs the training data to the learning model, and acquires an inference result (estimation result of the battery parameter) from the learning model. The battery management server 50 trains the learning model by feeding back an error between the ground truth data and the estimation result of the battery parameter (error backpropagation). As a result, each trained model 525 is generated.

### <Use Pattern>

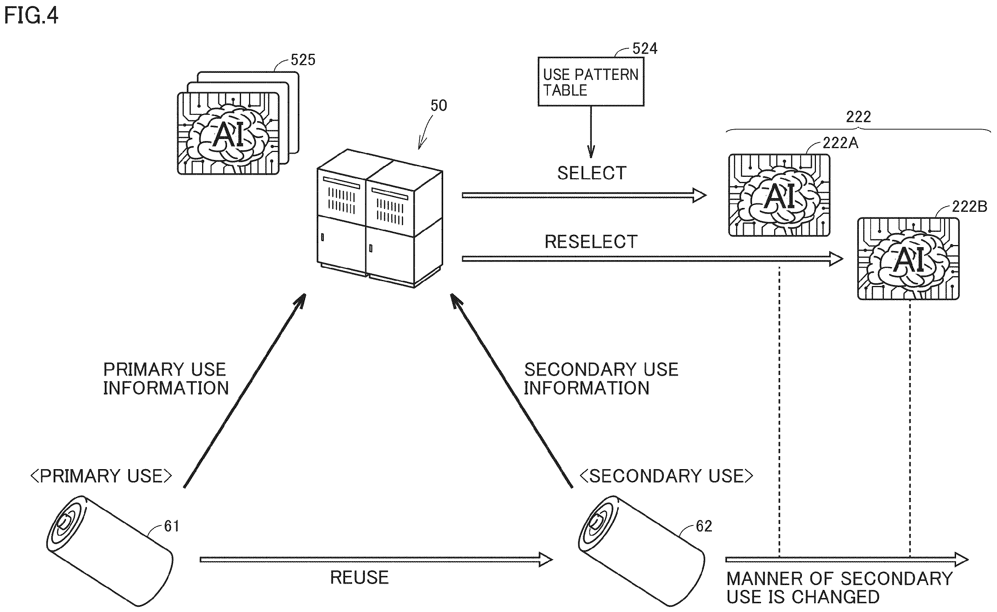

Fig. 4 is a conceptual diagram for explaining selection of a trained model in the present embodiment. Referring to Figs. 1 to 4, in the present embodiment, the battery management server 50 selects any trained model from among a plurality of trained models 525 prepared in advance, based on the primary use information of the battery 61 and the secondary use information of the battery 62, and provides the trained model to second server 20 as trained model 222.

In the example illustrated in Fig. 4, a trained model 222A is selected at the start of secondary use of the battery 62. However, the manner of use of the battery 62 may be changed during a period in which a battery parameter of the battery 62 is estimated using the trained model 222A after the start of use of the battery 62. In such a case, in the present embodiment, a trained model 222B dependent on the changed manner of use is reselected. The trained model 222A corresponds to "first model" according to the present disclosure, and the trained model 222B corresponds to "second model" according to the present disclosure.

In the following example, a plurality of use patterns are defined in accordance with the primary use information and the secondary use information. The plurality of use patterns are organized as a use pattern table 524.

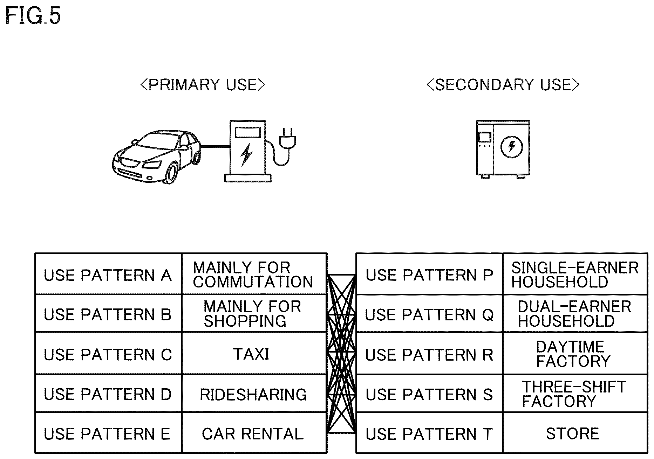

Fig. 5 is a diagram for explaining an example of classification of use patterns. In the example shown in Fig. 5, the manner of use of the battery 61 during primary use is classified into any one of the five use patterns A to E based on the primary use information. The use patterns A to E are, for example, patterns indicating a manner of use of the battery 61 mounted on the vehicle. The use pattern A is a pattern of use mainly for commutation, the use pattern B is a pattern of use mainly for shopping, the use pattern C is a pattern for taxi, the use pattern D is a pattern for ridesharing, and the use pattern E is a pattern for car rental.

Similarly, the manner of use of the battery 62 during secondary use is classified into any of the five use patterns P to T based on the secondary use information. The use patterns P to T are, for example, patterns indicating a manner of use of the battery 62 that is a stationary battery. The use pattern P is a pattern for a single-earner household, the use pattern Q is a pattern for a dual-earner household, the use pattern R is a pattern for a daytime factory, the use pattern S is a pattern for a three-shift factory, and the use pattern T is a pattern for a store.

In this example, the manner of use of the battery during primary use and during secondary use is classified into any of a total of 25 use patterns obtained by combining five use patterns A to E and five use patterns P to T.

Fig. 6 is a diagram illustrating the use pattern table 524. Referring to Figs. 5 and 6, in the use pattern table 524, for example, a battery type (typically, a model number), primary use information (for example, use patterns A to E), secondary use information (for example, use patterns P to T), and trained models (trained models M1 to M25) are associated with each other. As described above, the battery management server 50 (model storage unit 505) may store each of the plurality of trained models 525 in association with the primary use information and the secondary use information. The battery management server 50 selects any one trained model based on the battery type, the primary use information, and the secondary use information by referring to the use pattern table 524.

When the use pattern during secondary use is changed, the battery management server 50 reselects a trained model. As one specific example, when the use pattern during primary use is A (mainly for commutation) and the use pattern during secondary use is P (single-earner household), the battery management server 50 selects M1 as the trained model 222. Thereafter, when the use pattern during secondary use has changed from P (single-earner household) to Q (dual-earner household), the battery management server 50 changes the trained model 222 from M1 to M2. This makes it possible to use a trained model conforming to or optimized for the changed use pattern. Therefore, as compared with the case where the trained model M1 is continuously used, the battery parameter of the battery 62 during secondary use can be estimated with high accuracy.

### <Process Flow>

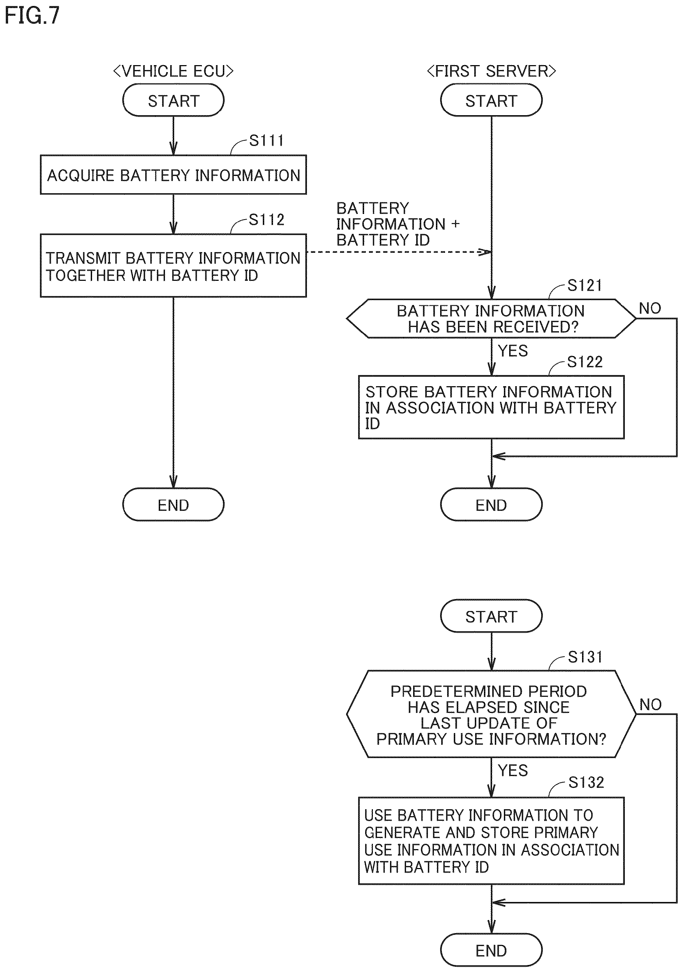

Fig. 7 is a flowchart showing an example of a processing procedure relating to acquisition of battery information and generation of primary use information during primary use of the battery 61. The process shown in this flowchart is executed when a predetermined condition is satisfied (for example, every predetermined cycle). Each step is typically realized by software processing by the vehicle ECU 30 or the first server 10, but may be realized by hardware (electrical circuit). Hereinafter, the step is abbreviated as S. The same applies to other flowcharts described later.

Referring to Figs. 1 and 7, in S111, the vehicle ECU 30 acquires battery information (such as raw data measured by various sensors) of the battery 61 during primary use. The vehicle ECU 30 transmits the acquired battery information together with the battery ID of the battery 61 to the first server 10 (S112).

In S121, the first server 10 determines whether battery information of the battery 61 has been acquired from the vehicle ECU 30. When the battery information has been acquired (YES in S121), the vehicle ECU 30 stores the battery information in the memory in association with the battery ID (S122).

In S131, the first server 10 determines whether a predetermined period has elapsed since the last update of the primary use information. When the predetermined period has elapsed (YES in S131), the first server 10 generates the primary use information of the battery 61 (a temperature history, a charging and discharging history, the number of times the battery has been charged and discharged, a start time and/or an end time of charging/discharging, an amount of change in shape, and the like, of the battery 61 during primary use) using the battery information of the battery 61. Then, the first server 10 stores the primary use information in the memory in association with the battery ID (S132).

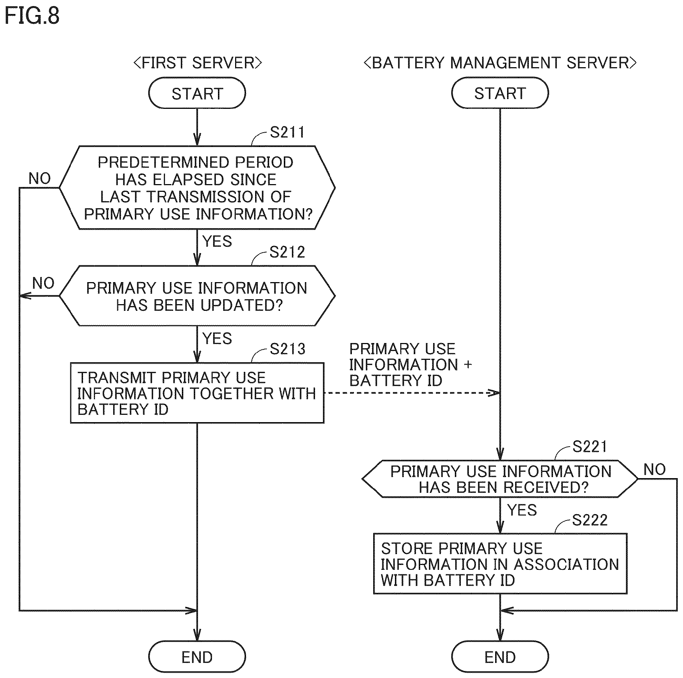

Fig. 8 is a flowchart illustrating an example of a processing procedure relating to transmission and reception of primary use information. Referring to Fig. 1, Fig. 2, and Fig. 8, in S211, the first server 10 determines whether or not a predetermined period of time has elapsed since the last transmission of the primary use information of the battery 61. When the predetermined period has elapsed (YES in S211), the first server 10 determines whether the current primary use information has been updated from the previous primary use information (S212). When the primary use information has been updated (YES in S212), the first server 10 transmits the current primary use information together with the battery ID to the battery management server 50 (S213).

In S221, the battery management server 50 determines whether the primary use information of the battery 61 has been received from the first server 10. When the primary use information has been received (YES in S222), the battery management server 50 stores the primary use information in the memory 52 (battery management database 504) in association with the battery ID.

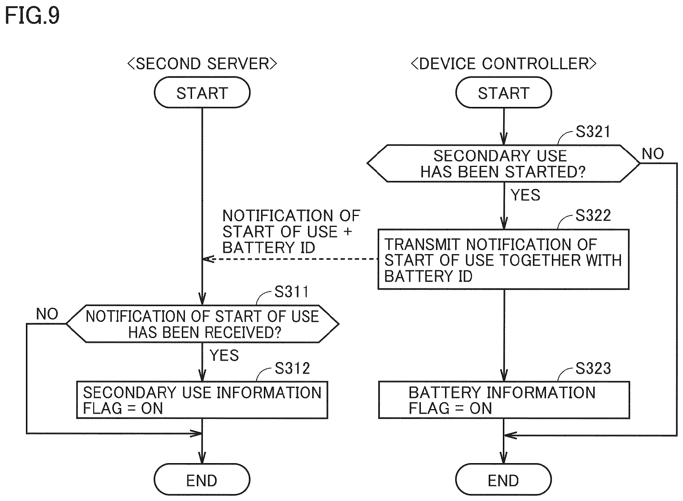

Fig. 9 is a flowchart illustrating an example of a processing procedure relating to the start of secondary use of the battery 62. Referring to Figs. 1, 2, and 9, in S321, the device controller 40 determines whether secondary use of the battery 62 has been started. When the secondary use of the battery 62 has been started (YES in S321), the device controller 40 transmits a notification (notification of start of use) indicating that the secondary use of the battery 62 is started to the second server 20 together with the battery ID (S322). Then, the device controller 40 sets the battery information flag to ON (S323).

In S311, the second server 20 determines whether the notification of start of use has been received from the device controller 40. When the notification of start of use has been received (YES in S311), the second server 20 sets the secondary use information flag to ON (S312).

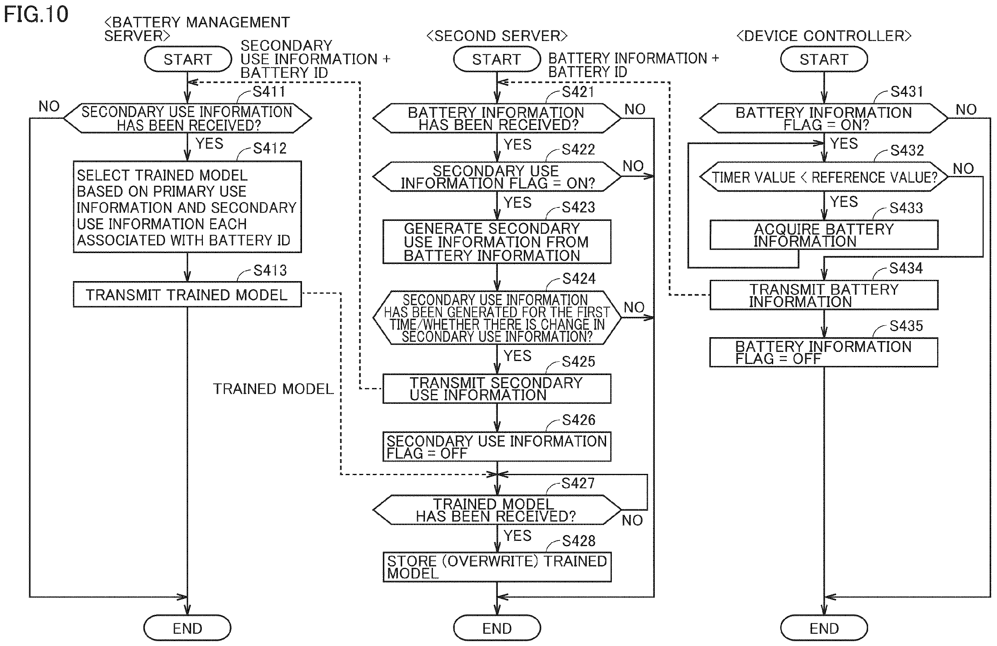

Fig. 10 is a flowchart illustrating an example of a processing procedure relating to selection of the trained model 525. Referring to Figs. 1, 2, and 10, in S431, the device controller 40 determines whether or not the battery information flag is ON. When the battery information flag is ON (YES in S431), the device controller 40 determines whether a timer value indicating an elapsed time from the start of secondary use is less than a reference value (S432). When the timer value is less than the reference value (YES in S432), the device controller 40 acquires battery information (raw data measured by various sensors, or the like) of the battery 62 (S433). When the timer value becomes equal to or larger than the reference value (NO in S432), the device controller 40 transmits the battery information together with the battery ID to the second server 20 (S434). Then, the device controller 40 returns the battery information flag from ON to OFF (S435).

In S434, instead of receiving the battery information from the device controller 40, the second server 20 may acquire information based on the operation of the administrator of the battery 62. More specifically, the administrator of the battery 62 may perform an operation (e.g., a response to a questionnaire) of selecting which use pattern (such as the use patterns P to T in Fig. 5) the secondary use of the battery 62 corresponds to, and the second server 20 may acquire the use pattern in accordance with the operation.

In S421, the second server 20 determines whether battery information has been received from the device controller 40. When the battery information has been received (YES in S421), the second server 20 determines whether or not the secondary use information flag is ON (S422). When the secondary use information flag is ON (YES in S422), the second server 20 generates secondary use information of the battery 62 (a temperature history, a charging and discharging history, the number of times the battery has been charged and discharged, a start time and/or an end time of charging/discharging, an amount of change in shape, and the like, of the battery 62 during secondary use) using the battery information of the battery 62 (S423). In S424, the second server 20 determines whether or not the secondary use information has been generated for the first time, and whether or not there is a change in the secondary use information generated this time, as compared with the secondary use information generated last time. When the secondary use information has been generated for the first time or when there is a change in the secondary use information (YES in S424), the second server 20 transmits the secondary use information together with the battery ID to the battery management server 50 (S425). Then, the second server 20 returns the secondary use information flag from ON to OFF (S426).

In S411, the battery management server 50 determines whether the secondary use information has been received from the second server 20. When the secondary use information has been received (YES in S411), the battery management server 50 selects any one trained model from among the plurality of trained models 525 based on the primary use information and the secondary use information each associated with the battery ID (S412). Since the selection method has been described in detail with reference to Figs. 5 and 6, the description thereof will not be repeated here. The battery management server 50 transmits the selected trained model to the second server 20 (S413).

In S427, the second server 20 determines whether the trained model has been received from the battery management server 50. When the trained model has been received (YES in S427), the second server 20 stores the received trained model in the memory 22 (S428). When the past trained model is stored, the second server 20 may overwrite and store the past trained model using the newly received trained model.

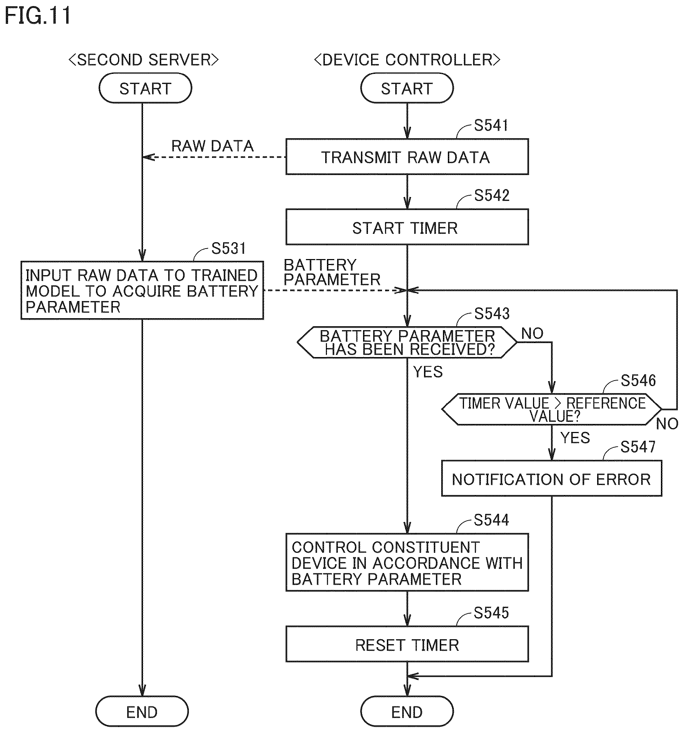

Fig. 11 is a flowchart illustrating an example of a processing procedure relating to inference using the trained model 222. Referring to Figs. 1, 2, and 11, the device controller 40 transmits battery information (raw data) of the battery 62 to the second server 20 (S541). In addition, the device controller 40 starts a timer for measuring an elapsed time from the transmission of the raw data (S542).

In S531, the second server 20 acquires the estimation result of the battery parameter by inputting the raw data to the trained model 222. The second server 20 transmits the battery parameter to the device controller 40.

In S543, the device controller 40 determines whether the battery parameter has been received from the second server 20. When the battery parameter has been received (YES in S543), the device controller 40 controls the constituent devices of the stationary power supply system in accordance with the battery parameter (S544). As one specific example, the device controller 40 controls the converter and/or the inverter connected to the battery 62 so as to suppress the charge/discharge power of the battery 62 as compared with the previous case. The device controller 40 may control the display to display the acquired battery parameters. Thereafter, the device controller 40 resets the timer (S545). On the other hand, when the battery parameter has not been received (NO in S543), the device controller 40 determines whether or not the timer value exceeds the reference value (S546). When the timer value exceeds the reference value (YES in S546), the device controller 40 notifies the user of the stationary power supply system of an error (S547). The device controller 40 may display the error on a HMI (Human Machine Interface) of the stationary power supply system, or transmit a mail or the like.

### <Conclusion>

As described above, in the present embodiment, when the battery management server 50 is notified by the second server 20 of the fact that the manner of use of the battery 62 during secondary use has changed, the battery management server 50 reselects a trained model from among the plurality of trained models 525 based on the new secondary use information. In other words, the battery management server 50 changes the trained model so as to use the trained model dependent on the changed manner of use. This enables the second server 20 to estimate the battery parameter with high accuracy, because the trained model conforming to or optimized for the changed manner of use is used by the second server 20.

### [Modifications]

The first server 10 and the vehicle ECU 30 may be integrated. That is, the function of the first server 10 may be incorporated in the vehicle ECU 30. Similarly, the second server 20 and the device controller 40 may be integrated, and the function of the second server 20 may be incorporated in the device controller 40.

In Fig. 1, the second server 20 includes the trained model 222, and the device controller 40 acquires the estimation result of the battery parameter from the second server 20. In other words, the second server 20 and the device controller 40 have a cloud system configuration. Alternatively, the device controller 40 may include the trained model 222, and the device controller 40 itself may acquire the battery parameters from the trained model 222. That is, an edge-type system configuration can also be employed.

The battery information may be collected from another device (for example, an administrator terminal of the batteries 61 and 62) instead of the vehicle ECU 30 and the device controller 40. As one example, the start time or the end time of charging and discharging of the batteries 61 and 62 can be extracted from the schedule information of the administrator terminal.

Although the present disclosure has been described and illustrated in detail, it is clearly understood that the same is by way of illustration and example only and is not to be taken by way of limitation, the scope of the present disclosure being interpreted by the terms of the appended claims.

## Claims

1. A battery management system (100) comprising:
a use information acquisition unit (501, 502) that acquires use information indicating a manner of use of a battery (61, 62);
a model storage unit (505) that stores a plurality of trained models (525) each trained to estimate a battery parameter indicating a state of the battery (61, 62), based on the use information; and
a model selection unit (506) that selects a trained model from among the plurality of trained models (525), wherein
when the manner of use of the battery (61, 62) is changed during a period in which a first model among the plurality of trained models (525) is used, the model selection unit (506) changes the trained model so as to use a second model dependent on the changed manner of use, among the plurality of trained models (525).

2. The battery management system (100) according to claim 1, wherein each of the plurality of trained models (525) is optimized to estimate, in accordance with the manner of use of the battery (61, 62) during primary use and secondary use of the battery (61, 62), the battery parameter during the secondary use of the battery (61, 62).

3. The battery management system (100) according to claim 1, wherein the model storage unit (505) stores each of the plurality of trained models (525) in association with information indicating a manner of primary use of the battery (61, 62) and information indicating a manner of secondary use of the battery (61, 62).

4. The battery management system (100) according to any one of claims 1 to 3, wherein the battery parameter includes a value indicating at least one of a state of charge, a state of health, a self-discharge amount, and an abnormality of the battery (61, 62).

5. A battery management method comprising:
acquiring use information indicating a manner of use of a battery (61, 62);
selecting a trained model from among a plurality of trained models (525) each trained to estimate, based on the use information, a battery parameter indicating a state of the battery (61, 62), wherein
the selecting includes changing, when the manner of use of the battery (61, 62) is changed during a period in which a first model among the plurality of trained models (525) is used, the trained model so as to use a second model dependent on the changed manner of use, among the plurality of trained models (525).
